(19) Europäisches Patentamt
European Patent Office
Office européen des brevets

(11) **EP 2 312 020 A1**

(12) **EUROPEAN PATENT APPLICATION**
published in accordance with Art. 153(4) EPC

(43) Date of publication:
**20.04.2011 Bulletin 2011/16**

(51) Int Cl.:
***C25D 1/04*** (2006.01)

(21) Application number: **09794432.6**

(22) Date of filing: **07.07.2009**

(86) International application number:
**PCT/JP2009/062362**

(87) International publication number:
**WO 2010/004988 (14.01.2010 Gazette 2010/02)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **07.07.2008 JP 2008176695**

(71) Applicant: **The Furukawa Electric Co., Ltd.**
**Chiyoda-ku**
**Tokyo 100-8322 (JP)**

(72) Inventors:
• **SUZUKI, Yuji**
**Tokyo 100-8322 (JP)**
• **SAITO, Takahiro**
**Tokyo 100-8322 (JP)**

(74) Representative: **Thun, Clemens**
**Mitscherlich & Partner**
**Patent- und Rechtsanwälte**
**Sonnenstrasse 33**
**80331 München (DE)**

(54) **ELECTROLYTIC COPPER FOIL AND COPPER-CLAD LAMINATE**

(57)     To provide an electrodeposited copper foil having flexibility and bending property equivalent to or better than that of rolled copper foil, an electrodeposited copper foil wherein regarding a crystal structure after heat treatment is applied to the electrodeposited copper foil wherein LMP defined as formula 1 is 9000 or more, either color tone of a red system or a blue system occupies 80% or more in a surface in the EBSP analysis is provided.

$$\text{Formula 1: LMP = (T+273) * (20+Log t)}$$

wherein 20 is a material constant of copper, T is temperature (°C), and t is time (Hr).
    Preferably, relative intensity of (331) face against (111) face is 15 or more in the X-ray diffraction of the electrodeposited copper foil after the heat treatment is applied to the electrodeposited copper foil.

FIG.1

RED SYSTEM PORTION
赤系部

青系部
BLUE SYSTEM PORTION

**Description**

TECHNICAL FIELD

The present invention relates to an electrodeposited copper foil being excellent in bending property and flexibility. Further, the present invention relates to copper clad laminate (hereafter it may be referred as CCL) using the copper foil, particularly relates to a copper clad laminate being suitable for use of high density and high functionality.

BACKGROUND ART

At present in downsizing electronic apparatus product, in the circumstance that bending angle (R) of hinge portion of cellular phone tends to become small increasingly, desire for the bending property of CCL becomes rigorous increasingly.
As an important property of copper foil for improving bending property, thickness, surface flatness, size of crystalline grain, identity of crystal orientation, etc. are mentioned. Moreover, for the purpose of density growth of wiring according to the miniaturization of an electric product, it is important problem to use a space effectively as much as possible, and it is becoming indispensable to adopt a polyimide film so that the change of shape of CCL is easily possible. However, adhesion (lamination) of a copper foil and a polyimide film is rather difficult, and the bonding strength and the flexibility of the copper foil to be adhered on the polyimide film are becoming necessary and indispensable properties.
As a copper foil satisfying these properties, the rolled copper foil produced in the particular production process in which many crystal orientations of (200) faces exist is employed in many cases at the present situation.
However, it is thought that the factor for improving the bending property is that many crystals having identical crystal orientation exist, rather than that (200) faces are suitable.
At the present situation, as the above rolled foil, all is copper foil in which many (200) faces exist, and regarding even the electrodeposited copper foil, it has a crystal structure in which each crystal orientation exists disorderly. Therefore, there is no electrodeposited copper foil having flexibility and bending property such as the rolled foil, and appearance of electrodeposited copper foil is desired which has flexibility and bending property equal to or better than those of the rolled copper foil.
To respond to the desire, the electrodeposited copper foil having a system of identical crystal orientation is preferable, however at the present situation, such a electrodeposited copper foil has not been developed yet.

SUNIMARY OF INVENTION

TECHNICAL PROBLEM

The problem to be solved by the invention is to provide an electrodeposited copper foil which has flexibility and bending property equal to or better than those of the rolled copper foil and provide the CCL having flexibility and bending property by using such copper foil. In particular, in the electrodeposited copper foil, mechanical property and flexibility are improved in the heat history applied at the adhesion of the electrodeposited copper foil and polyimide film, therefore, it is to provide an electrodeposited copper foil for CCL capable of responding to the miniaturization of the electric product.

SOLUTION TO PROBLEM

An electrodeposited copper foil of the present invention is an electrodeposited copper foil wherein regarding a crystal structure after heat treatment applied to the electrodeposited copper foil wherein LMP (Larson-Miller parameter) defined as formula 1 is 9000 or more, either color tone of a red system or a blue system occupies 80% or more in a surface in the EBSP (Electron Backscatter Diffraction Pattern) analysis.

$$\text{Formula 1: LMP} = \text{(T+273)} * \text{(20+Log t)}$$

wherein 20 is a material constant of copper, T is temperature (°C), and t is time (Hr).
In the electrodeposited copper foil of the present invention, preferably, relative intensity of (331) face against (111) face in the X-ray diffraction of the electrodeposited copper foil to which the heat treatment is applied is 15 or more.
In the electrodeposited copper foil of the present invention, preferably, in the crystal structure after the heat treatment is applied, crystal grains having crystal grain diameter being 5 μm or more are 70% or more, and relative intensity of (331) face against (111) face in the X-ray diffraction is 15 or more.

In the electrodeposited copper foil of the present invention, preferably, the electrodeposited copper foil to which the heat treatment is applied has tensile strength of 20 $KN/cm^2$ or less and 0.2% proof stress of 10 $KN/cm^2$ or less.

In the electrodeposited copper foil of the present invention, preferably, in the SIMS (Secondary Ion Mass Spectrometry of depth direction of cross-section of the copper foil, at least chlorine (Cl) is less than 0.5%, nitrogen (N) is less than 0.005%, and sulfur (S) is less than 0.005% as intensity ratios against copper (Cu).

In the electrodeposited copper foil of the present invention, preferably, as a surface roughness of at least one surface of the electrodeposited copper foil, Rz = 1.5 $\mu$m or less.

Moreover, preferably, a surface treated layer is formed on at least one surface of the electrodeposited copper foil for the purpose of adhesion property, heat resistance, chemical resistance, and rust prevention.

A copper clad laminate of the present invention is a copper clad laminate wherein the above electrodeposited copper foil is laminated on an insulating substrate.

ADVANTAGEOUS EFFECTS OF INVENTION

The present invention can provide an electrodeposited copper foil which has flexibility and bending property equal to or better than those of the rolled copper foil. Moreover, the present invention can respond to the CCL which has flexibility and bending property using the electrodeposited copper foil.

In particular, an electrodeposited copper foil for CCL can be provided more cheaply than the rolled copper foil, which can respond to miniaturization of the electric product, wherein the mechanical property and flexibility of the electrodeposited copper foil are improved in the heat history applied at the adhesion of the electrodeposited copper foil and polyimide film.

BRIEF DESCRIPTION OF DRAWINGS

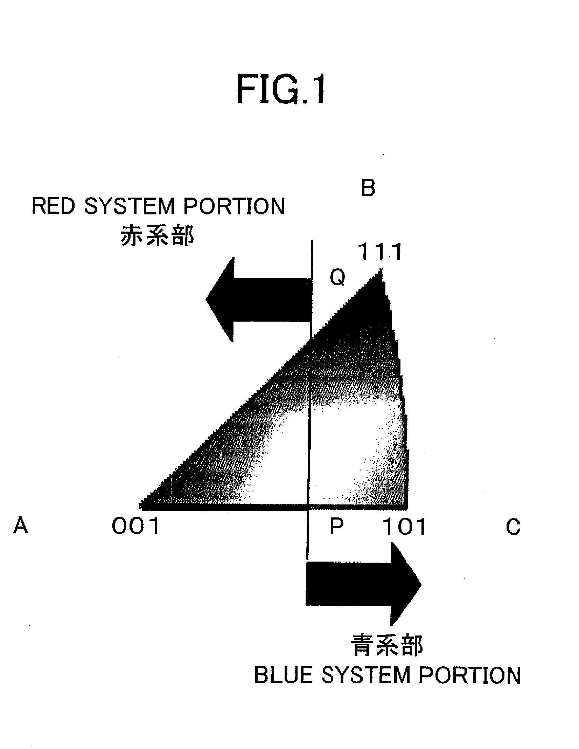

[FIGS. 1] FIG. 1 is drawing of an EBSP identical crystal range.

DESCRIPTION OF EMBODIMENTS

An electrodeposited foil is usually produced by electrodepositing foil production apparatus. The electrodepositing foil production apparatus comprises a rotating drum-like cathode (the surface is a product made from SUS or titanium), and an anode (lead or precious-metals oxide covered titanium electrode) arranged to the cathode at concentric circle shape. In the electrodepositing foil production apparatus, current is applied among both electrodes with supplying electrolytic solution so that copper is deposited on the cathode surface at predetermined thickness, and then the copper in the shape of foil is peeled off from the cathode surface. The copper foil at this stage may be termed untreated copper foil in the present description. The surface of the untreated copper foil which is in contact with the electrolytic solution is termed matte surface, and the surface in contact with the rotating drum-like cathode is termed gloss surface (shiny surface). Although the above is explained regarding the electrodepositing foil production apparatus adopting the rotating cathode, the copper foil may be produced in the electrodepositing foil production apparatus adopting the cathode in the plate shape.

In the present invention, the copper foil is produced by precipitating copper on the drum-like cathode or the cathode in the plate shape. Regarding the surface roughness of the cathode for precipitating copper, by using the cathode of Rz: 0.1 to 2.0 $\mu$m, the surface roughness of the shiny surface of the electrodeposited copper foil of the present invention can be formed into Rz: 0.1 to 2.0 $\mu$m.

It is difficult to produce an electrodeposited copper foil having surface roughness of Rz 0.1 $\mu$m or less under consideration of polishing technology of the cathode, etc., and it is thought that it is impossible to produce it in mass production. Also, it is because that if the surface roughness is formed to 2.0 $\mu$m or more, the bending property becomes very bad, and the property becomes not available which the present invention seeks, as well as it becomes difficult to form the roughness of the matte surface to 1.5 $\mu$m or less.

The roughness of the matte surface of the electrodeposited copper foil is Rz: 0.1 to 1.5 $\mu$m. The roughness of 0.1 $\mu$m or less is very difficult even if gloss plating is performed and is impossible to be produced practically. Also, the upper limit of roughness is preferably 1.5 $\mu$m because the bending property becomes bad when the surface of the electrodeposited copper foil becomes rough as described above.

The roughness of the shiny surface and matte surface is preferably Rz: 1 $\mu$m or less. In addition to that the roughness Ra of the shiny surface and matte surface is preferably Ra: 0.3 $\mu$m or less, and especially Ra: 0.2 $\mu$m or less most suitably.

Moreover, the thickness of the electrodeposited copper foil is preferably 3 to 210 $\mu$m. It is because the copper foil having thickness of 2 $\mu$m or less cannot be produced well in relation with handling technology, etc., and not practical. The upper limit of the thickness is about 210 $\mu$m according to the usage of circuit board at the present time. It is because, it is difficult to be thought that the electrodeposited copper foil having thickness of 210 μm or more is used as copper foil for circuit board, and the advantage regarding cost due to that the electrodeposited copper foil is used would disappear.

As a copper electrolytic solution for deposition of the above mentioned electrodeposited copper foil, there are copper sulfate plating solution, copper pyrophosphate plating solution, copper sulfamate plating solution, etc., under consideration of a cost aspect etc., copper sulfate plating solution is preferred.

Regarding the copper sulfate plating solution, the sulfuric acid concentration of 20 to 150 g/l is preferred, and 30 to 100 g/l is especially preferred.

If the sulfuric acid concentration becomes less than 20 g/l, it becomes difficult to carry current, and therefore practical operation becomes difficult, and the uniformity of plating and electrodeposition property also become worse. If the sulfuric acid concentration becomes more than 150 g/l, since the solubility of copper decreases, sufficient copper concentration becomes not available, and therefore practical operation becomes difficult. Also, corrosion of apparatus is promoted.

The copper concentration of 40 to 150 g/l is preferred, and 60 to 100 g/l is especially preferred.

If the copper concentration becomes less than 40 g/l, it becomes difficult to secure current density being capable of operating practically in the production of electrodeposited copper foil. To increase the copper concentration more than 150 g/l is not practical due to that particular high temperature becomes necessary.

The current density of 20 to 200 A/dm$^2$ is preferred, and 30 to 120 A/dm$^2$ is especially preferred.

If the current density becomes less than 20 A/dm$^2$, the production efficiency in the production of the electrodeposited copper foil becomes especially low and it is not practical. It is because that to increase the current density more than 200 A/dm$^2$ is not practical due to that particular high copper concentration, high temperature, and high flow rate become necessary, and heavy load is applied on the production apparatus of the electrodeposited copper foil.

The temperature of the electrodepositing bath of 25 to 80°C is preferred, and 30 to 70°C is especially preferred. If the temperature of the bath becomes lower than 25°C, it becomes difficult to secure sufficient copper concentration and current density in the production of electrodeposited copper foil and it is not practical. Also, to raise the temperature higher than 80°C is very difficult from the points of operation and apparatus, and is not practical.

In the present embodiment, chlorine is added to the electrolytic solution according to the necessity.

The chlorine concentration of 1 to 100 ppm is preferred, and 10 to 50 ppm is especially preferred. If the chlorine concentration becomes lower than 1 ppm, it becomes difficult to obtain the effect of the additive described below, and if it becomes higher than 100 ppm, normal plating becomes difficult.

The above electrodeposition condition is suitably adjusted within each range to the condition so that deposition of copper, burning of plating, or other failure does not occur.

A reaction product of one or more kind(s) of di- or poly- halogenated chain aliphatic saturated hydrocarbon compound or one or more kind(s) of di- or poly- halogenated chain aliphatic saturated hydrocarbon compound having one or two or more ether bonding(s), or combination of one or more kind(s) of di- or poly-halogenated chain aliphatic saturated hydrocarbon compound and one or more kind(s) of di- or poly-halogenated chain aliphatic saturated hydrocarbon compound having one or two or more ether bonding(s), and heterocyclic compound having two nitrogen atoms is added into the copper sulfate plating bath for producing the electrodeposited copper foil as leveler.

The carbon number of di- or poly- halogenated chain aliphatic saturated hydrocarbon compound is generally 1 to 30, preferably 2 to 18, more preferably 4 to 8. Specifically, there are mentioned 1, 3-dichloro-2-propanol, 1,4-dichloro-2,3-butanediol, 1-bromo-3-chloroethane, 1-chloro-3-iodoethane, 1,2-diiodoethane, 1,3-dichloropropane, 1,2,3-trichloropropane, 1-bromo-3-chloropropane, 1,3-dibromopropane, 1,2-dichloroethane, 1-chloro-3-iodopropane, 1,4-dichloro-2-butanol, 1,2-dibromoethane, 2,3-dichloro-1-propanol, 1,4-dichlorocyclohexane, 1,3-diiodopropane, 1-bromo-3-chloro-2-methylpropane, 1,4-dichlorobutane, 1,4-dibromobutane, 1,5-dichloro[3-(2-chloroethyl)] pentane, 1,6-dibromohexane, 1,8-dichlorooctane, 1,10-dichlorodecane, 1,18-dichlorooctadecane, etc. These compounds are used independently or with combining plural thereof.

The carbon number of di- or poly- halogenated chain aliphatic saturated hydrocarbon compound having one or two or more ether bonding(s) is generally 4 to 30, preferably 4 to 12, more preferably 6 to 10. Specifically, there are mentioned 2,2'-dichloroethyl ether, 1,2-bis(2-chloroethoxy)ethane, Diethylene glycol bis(2-chloroethyl)ether, triethylene glycol bis(2-chloroethyl)ether, 2,2'-dichloropropyl ether, 2,2'-dichlorobutyl ether, Tetraethylene glycol bis(2-bromoethyl) ether, heptaethylene glycol bis(2-chloroethyl)ether, tridecaethylene glycol bis(2-bromoethyl)ether, etc. These compounds are used independently or with combining plural thereof.

As a heterocyclic compound having two nitrogen atoms, there are mentioned piperazine, triethylenediamine, 2-methylpiperazine, 2, 6-dimethylpiperazine, 2,5-dimethylpiperazine, homopiperazine, 2-pyrazoline, imidazole, 2-methylimidazole, 2-ethylimidazole, 2-propylimidazole, 4-methylimidazole, histidine, 1-(3-aminopropyl)imidazole, 2-imidazoline, 3-imidazoline, 4-imidazoline, 2-methyl-2-imidazoline, pyrazole, 1-methylpyrazole, 3-methylpyrazole, 1, 3-dimethylpyrazol, 1,4-dimethylpyrazol, 1,5-dimethylpyrazol, 3,5-dimethylpyrazol, benzimidazole, indazole, piperazine, 2-methylpiperazine, 2,5-dimethylpiperazine, pyrimidine, pyridazine, etc. These compounds are used independently or with combining plural thereof. In particular, 2-pyrazoline, pyrazole imidazole, 2-methylimidazole, 2-imidazoline, 3-imidazoline, 4-imidazoline, 2-methyl-2-imidazoline, etc. are preferred.

In the present invention, a reaction product of combination of di- or poly- halogenated chain aliphatic saturated hydrocarbon compound and di- or poly-halogenated chain aliphatic saturated hydrocarbon compound having one or two or more ether bonding(s) and heterocyclic compound having two nitrogen atoms can also be used. Furthermore, a reaction product added with dimethylamine, diethanolamine, ethylenediamine, or other aliphatic amino compounds, phenylenediamine or other aromatic amino compounds, succinylchloride, glutarylchloride, fumarylchloride, dichloroxylylene, phthloylchloride or other compounds having a plurality of reactive groups as the third ingredient can also be used. However, it is not preferred to use epihalohydrin such as epichlorohydrin as the third reaction ingredient at the point that the expected effect of the reaction product is not acquired.

The reaction temperature for production of reaction product of above mentioned di- or poly-halogenated chain aliphatic saturated hydrocarbon compound or di- or poly- halogenated chain aliphatic saturated hydrocarbon compound having one or two or more ether bonding(s) and heterocyclic compound having two nitrogen atoms is room temperature to 200°C, preferably 50°C to 130°C.

The reaction time for production of reaction product of above mentioned di- or poly- halogenated chain aliphatic saturated hydrocarbon compound or di- or poly-halogenated chain aliphatic saturated hydrocarbon compound having one or two or more ether bonding(s) and heterocyclic compound having two nitrogen atoms is 1 hour to 100 hours, preferably 3 hours to 50 hours.

The reaction for production of reaction product of above mentioned di- or poly- halogenated chain aliphatic saturated hydrocarbon compound or di- or poly-halogenated chain aliphatic saturated hydrocarbon compound having one or two or more ether bonding(s) and heterocyclic compound having two nitrogen atoms can be carried out without solvent, however, solvent may be used. As the solvent, there are mentioned methanol, ethanol, 1-propanol, isopropanol, t-butanol, or other alcohol, dimethylformamide, dioxane, tetrahydrofuran, methylcellosolve, ethylcellosolve, dimethylcellosolve, diethylcellosolve, etc.

Regarding the reaction for production of reaction product of above mentioned di- or poly-halogenated chain aliphatic saturated hydrocarbon compound or di- or poly- halogenated chain aliphatic saturated hydrocarbon compound having one or two or more ether bonding(s) and heterocyclic compound having two nitrogen atoms, halogen is sometimes generated during the reaction. The reaction may proceed with containing the halogen, however, preferably it may be halogen free reaction product by the public known method, for example the elimination method by ion exchange, and the elimination method by insolubilizing as alkali metal halide in the reaction with alkali metal hydroxide. Either reaction product containing halogen or halogen free reaction product may be employed according to the performance of copper electrodepositing solution.

As a brightener used in the present embodiment, it may be chosen suitably from public known things, and there are mentioned for example 3-mercaptopropanesulfonic acid and its salt, bis(3-sulfopropyl)disulfide and its salt, N,N-dimethyldithiocarbamic acid (3-sulfopropyl) ester, N,N-dimethyldithiocarbamic acid (3-sulfoethyl) ester, sodium 3-(benzothiazolythio) ethyl sulfonate, pyridinium propyl sulfobetaine, etc.

In the case where polymer is added to the copper electrodepositing solution, it may be chosen suitably from public known things, and there are mentioned for example polyethylene glycol, polypropylene glycol, copolymer of polyethylene glycol and a polypropylene glycol, C1 - C6 alkyl monoether of those three kinds of glycols, polyoxyethylene glyceryl ether, polyoxypropylene glyceryl ether, polyoxyethylene polyoxypropylene glyceryl ether, etc. having a molecular weight of 200 or more. The polymer having molecular weight of 500 to 100,000 is preferred.

Each additive is added with varying the quantity and ratio within the range of 0.1 to 1000 ppm.
The above mentioned additive added into the electrodepositing plating solution, especially the above mentioned leveler has a property which is not incorporated as an impurity into the copper foil.

The copper foil of the present invention is a copper foil wherein regarding a crystal structure after heat treatment applied to the electrodeposited copper foil wherein LMP defined as the above mentioned formula 1 is 9000 or more, either color tone of a red system or a blue system occupies 80% or more in a surface in the EBSP analysis. The range is shown in Fig. 1. Here, regarding the color tone, when each point of a figure is set to A, B or C as shown in Fig. 1, point P is located which divides the line of A and C into AP:CP = 2:1, and point Q is located at the point where the line drawn from the point P being perpendicular to AC crosses AB, the color tone is defined as that right side of the line is the blue system and the left side of the line is the red system.

It is because, if the above mentioned color tone is lower than 80 %, it becomes difficult for crystal to recrystallize, the crystal does not become large when thermal treatment is performed, and crystals having different crystal orientation exist at random, and as a result the tendency is revealed that crystal slip becomes worse and bending property becomes worse.

It is preferably a copper foil wherein the relative intensity of (331) face against (111) face is 15 or more in the X-ray diffraction of the above mentioned copper foil (X-ray diffraction data was measured by using X-ray diffraction apparatus of manufacturer: Rigaku, apparatus name: Geiger flex RAD-A (formed in PC)), and the crystal structure constructed by the color tone of the blue system (which is specifically described in the Fig. 1 as the right side blue system range) in the EBSP analysis occupies 80% or more on the whole.

Regarding the electrodeposited copper foil produced by the above mentioned condition, it is preferable that regarding at least chlorine (Cl), nitrogen (N) and sulfer (S) among the elements incorporated into the copper from the plating solution and additive elements, in the SIMS (Secondary Ion Mass Spectrometry) of each part of depth direction of cross-section of the copper foil, at least chlorine (Cl) is less than 0.5%, nitrogen (N) is less than 0.005%, and sulfur (S) is less than 0.005% as intensity ratios against copper (Cu). Furthermore, it is more preferable that regarding oxygen (O) and carbon (C), oxygen (O) is less than 1 %, and carbon (C) is less than 0.1%.

The electrodeposited copper foil of the present invention is a copper foil wherein there is little impurity as a whole, and there is not much impurity locally. The above produced copper foil is the electrodeposited copper foil wherein the crystal grains of maximum length of 5 $\mu$m or more exist in the ratio of 70% or more, by performing heat treatment wherein LMP defined as formula 1 is 9000 or more.

$$\text{Formula 1: LMP = (T+273) * (20+Log t)}$$

wherein 20 is a material constant of copper, T is temperature (°C), and t is time (Hr).

In the measuring method of the maximum length of crystal grain, microscope photograph of cross-section of the copper foil is taken, the maximum length of crystal grain is measured in the area in the range of 50 $\mu$m x 50 $\mu$m or its equivalent area, the area occupied by the crystal grain of the length of 5 $\mu$m or more is measured, to calculate and confirm which % the measured area is to the area of whole cross-section.

The relative intensity of (331) face against (111) face measured in the above mentioned X-ray diffraction after the heat treatment is preferably 15 or more.

Furthermore, when the heat treatment is applied, preferably tensile strength is 20 KN/cm$^2$ or less and 0.2% proof stress is 10 KN/cm$^2$ or less. And the proof stress of 8 KN/cm$^2$ or less is the most preferable.

On at least one surface of the above mentioned electrodeposited copper foil a surface treated layer is formed. Specifically, there are mentioned a roughening treated layer for the purpose of improving adhesion property due to anchor effect, surface treated layer for the purpose of adhesion property, heat resistance, chemical resistance, and rust prevention. Also, regarding the roughening treated layer, it is not necessary treatment if the surface treated layer is able to achieve the objective performance. In the surface treated layer, as the metallic surface treated layer there are mentioned simple substance of Ni, Zn, Cr, Si, Co and Mo, or alloy thereof, or hydrate thereof. As a example of treatment for depositing an alloy layer, at least one kind of metal of Ni, Si, Co and Mo or alloy containing one kind of metal of Ni, Si, Co and Mo is deposited, then Zn is deposited and Cr is deposited. In the case that the metallic surface treated layer is not formed as an alloy layer, the thickness of metal which deteriorate an etching property such as Ni or Mo is preferably 0.8 mg/dm$^2$ or less. Also, In the case that Ni or Mo is deposited as alloy, the thickness thereof is preferably 1.5 mg/dm$^2$ or less. Furthermore, regarding Zn, when the deposition amount is too much, it may dissolve at the time of etching and cause deterioration of peel strength, therefore it is preferably 2 mg/dm$^2$ or less.

An example of plating solution and plating condition for forming (depositing) the above mentioned metallic surface treated layer is described below.

| [Ni plating] | |
| --- | --- |
| $NiSO_4 \cdot 6H_2O$ | 10 to 500 g/l |
| $H_3BO_3$ | 1 to 50 g/l of |
| Current density | 1 to 50 A/dm$^2$ |
| Bath temperature | 10 to 70°C |
| Processing time | 1 second to 2 minutes |
| PH | 2.0 to 4.0 |

| [Ni-Mo plating] | |
| --- | --- |
| $NiSO_4 \cdot 6H_2O$ | 10 to 500 g/l |
| $Na2MoO_4 \cdot 2H_2O$ | 1 to 50 g/l |
| Trisodium citrate dihydrate | 30 to 200 g/l |
| Current density | 1 to 50A/dm$^2$ |
| Bath temperature | 10 to 70°C |
| Processing time | 1 second to 2 minutes |
| PH | 1.0 to 4.0 |

```
[Mo-Co plating]
Na₂MoO₄ · 2H₂O          1 to 30 g/l
CoSO₄ · 7H₂O            1 to 50 g/l
Trisodium citrate dihydrate   30 to 200 g/l
Current density        1 to 50A/dm²
Bath temperature       10 to 70°C
Processing time        1 second to 2 minutes
PH                     1.0 to 4.0
```

```
[Zn plating]
Zinc oxide             2 to 40 g/dm³
Sodium hydroxide       10 to 300 g/dm³
Temperature            5 to 60°C
Current density        0.1 to 10 A/dm²
Processing time        1 second to 2 minutes
PH                     1.0 to 4.0
```

```
[Cr plating]
CrO₃                   0.5 to 40 g/l
PH                     3.0 or less
Solution temperature   20 to 70°C
Processing time        1 second to 2 minutes
Current density        0.1 to 10 A/dm²
PH                     1.0 to 4.0
```

On the these metallic surface treated layer, silane is coated. As for the silane to be coated, there are mentioned generally used amino-based, vinyl-based, cyano group-based, and epoxy-based silanes. In particular, when the film to be adhered is polyimide, amino-based or cyano group-based silane has an effect for improving the peel strength. The electrodeposited copper foil performed with these treatments is adhered to the film, and copper clad laminate is formed.

Although the present invention is explained based on an examples below, the present invention is not limited to these.

(1) Foil producing

Examples 1 to 5, comparative examples 1 to 3 Producing conditions such as composition of the electrodepositing solution are shown in Table 1. After the copper sulfate plating solution shown in Table 1 was passed through the charcoal filter for the cleaning treatment and was added the additive shown also in Table 1 at the predetermined concentration, untreated electrodeposited copper foil of thickness of 18 μm was produced by electrodeposition foil production by the rotating drum type foil production apparatus with the current density shown in Table 1.

[Table 1]

| | production condition | | | | | | | | | | current density (A/dm2) |
| | copper sulfate plating solution | | | additive | | | | | | | |
| | | | | leveler | | brightener | | polymer | | Cl | |
| | copper (g/ℓ) | sulfuric acid (g/ℓ) | temperature (°C) | kind | concentration (ppm) | kind | concentration (ppm) | kind | concentration (ppm) | concentration (ppm) | |
| examplel1 | 60 | 60 | 40 | 4 | 10 | 7 | 20 | - | - | 25 | 30 |
| example2 | 60 | 50 | 50 | 3 | 100 | 6 | 10 | - | - | 30 | 40 |
| example3 | 80 | 75 | 55 | 2 | 100 | SPS | 20 | - | - | 20 | 50 |
| example4 | 70 | 50 | 45 | 1 | 1000 | MPS | 1 | - | - | 20 | 30 |
| example5 | 50 | 40 | 50 | 1 | 10 | MPS | 1 | PEG | 100 | 25 | 35 |
| comparative example1 | 70 | 60 | 55 | 5 | 60 | MPS | 1 | - | - | 30 | 55 |
| comparative example2 | 80 | 90 | 60 | 5 | 100 | MPS | 7 | - | - | 35 | 55 |
| comparative example3 | 90 | 100 | 60 | 5 | 50 | MPS | 10 | - | - | 20 | 55 |

* leveler 1 : reaction product of 1,3-dibromopropane and piperazine 2 : reaction product of 2,2'-dichloroethylether and 2-imidazoline 3 : reaction product of 1,3-dichloropropane and 2-methyl-2-imidazoline 4 : reaction product of 1,4-dichloro-2-butanol and 2-pyrazoline 5 : low molecular weight glue * brightener MPS : sodinm 3-mercaptopropanesulfonate SPS : sodinm bis(3-sulfopropyl)disulfide 6 : sodinm N,N-dimethyldithiocarbamate 7 : sodinm 3-(benzothiazolyl-2-thio)propylsulfonate * polymer

PEG : polyethylen glycol

EP 2 312 020 A1

The produced untreated electrodeposited copper foils of examples and comparative examples were divided into three samples, and one sample among them was used to measure a amount of impurity element contained inside and surface roughness. And, the above mentioned unused one sample was performed with thermal treatment and used for observation of cross-section crystal grain, analysis of EBSP, X-ray diffraction, and tensile test. At last, remained unused one sample was thermal compression bonded with a polyimide sheet and used for bending test. Details of each measurement and test are described below.

[Measurement of the amount of impurity element]

In SIMS analysis, the amounts of impurity elements inside the untreated electrodeposited copper foils of examples 1 to 5 and comparative examples 1 to 3 were measured with digging in the depth direction. Measured elements are oxygen (O), carbon (C), chlorine (Cl), nitrogen (N), and sulfur (S). The SIMS analysis was performed under the measuring condition described below.

Primary ion :                             : $Cs^+$ (5 kV, 100nA)
secondary ion                         : copper (Cu) $^{63}Cu^-$ · chlorine
(Cl) $^{35}Cl^-$ · nitrogen (N) $^{14}N+^{63}Cu^-$ · sulfur (S) $^{34}S^-$ · oxygen (O) $^{16}O^-$ · carbon (C) $^{12}C^-$
Sputtering field                       : 200 $\mu$m x 400 $\mu$m

Because the surface of the untreated electrodeposited copper foil was influenced by dirt and oxide coating layer, the measurement started after removing until 2 $\mu$m in the depth direction from the surface by sputtering, and analysis was performed until 4 $\mu$m in the depth direction. Relative intensities were calculated from average intensity of each measured element and average intensity of copper. Calculated results of relative intensities are shown in Table 2.

[Measurement of surface roughness]

Surface roughness Rz and Ra of the untreated electrodeposited copper foils of each example and each comparative example were measured using the contact type surface roughness meter. The surface roughness Rz and Ra are defined as JIS B 0601-1994 "Definitions and designation of surface roughness", Rz is "ten point average roughness", and Ra is "calculated average roughness". Reference length was set to 0.8 mm and measurement was carried out. Measurement results are shown in Table 2.

[Heating conditions]

The untreated electrodeposited copper foil of each example and each comparative example was performed with a thermal treatment at 320°C, for 1 hour, wherein LMP value of above mentioned formula 1 is 9000 or more, in a nitrogen atmosphere.

[Observation of a cross-section crystal grain]

After the untreated electrodeposited copper foil of each example and each comparative example was performed with the thermal treatment under the above mentioned thermal condition, photograph of cross-section of the copper foil was taken using electron microscope, and the area ratio occupied by the crystal grain of the length of 5 $\mu$m or more in the range of 50 $\mu$m x 50 $\mu$m was measured and calculated. The result of observation of the cross-section of crystal grain is shown in Table 3.

[EBSP analysis]

It is as mentioned above. The result of EBSP analysis is shown in Table 3.

[Calculation of the relative intensity by X-ray diffraction]

It is as mentioned above. The result of calculation of the relative intensity by X-ray diffraction is shown in Table 3.

[Tensile strength]

After the untreated electrodeposited copper foil of each example and each comparative example was performed with the thermal treatment under the above mentioned thermal condition, it was cut into test piece of length 6 inch and width 0.5 inch, and 0.2 % proof stress and Young's modulus were measured using tensile tester. Tensile speed was set 50 mm/min. The result of tensile test is shown in Table 4.

In the relative curve of distortion and stress, a tangent line is drawn to the curve at 0% of distortion, a straight line is drawn in parallel with the tangent line to the point of distortion of 0.2 %, and the stress at the crossing point of the straight line and the curve divided by the cross-section is 0.2% proof stress. The result of tensile test is shown in Table 4.

[Bending property test]

The untreated electrodeposited copper foil of each example and each comparative example and polyimide film of thickness of 25 $\mu$m were compression bonded under the thermal condition at 330°C and for 20 minutes, and the polyimide film laminated electrodeposited copper foil was formed. Obtained polyimide film laminated electrodeposited copper foil was subjected to etching to form a circuit pattern, and a polyimide cover film was compression bonded under the thermal condition at 330°C and for 20 minutes on the circuit formation surface remaining current carrying portion, then MIT sample was obtained. Bending property test was performed to the obtained sample under the condition described below until the circuit was broken.

Number of bending times of comparative example 1 which showed the worst number of bending times was set 1, and evaluation of bending property was made as relative evaluation as multiple number to comparative example 1. The result of bending property test is shown in Table 4.

Bending radius R : 0.8 mm
Angle of bending : $\pm$135°
Bending speed : 175 times/min
Load : 500g

[Table 2]

| | relative intensity to copper in SIMS analysis (%) | | | | | surface roughness | | | |
| --- | --- | --- | --- | --- | --- | --- | --- | --- | --- |
| | | | | | | matte surface | | shiny surface | |
| | N | S | Cl | O | C | Ra($\mu$m) | Rz($\mu$m) | Ra($\mu$m) | Rz($\mu$m) |
| example1 | 0 | 0 | 0.28 | 0.53 | 0.06 | 0.07 | 0.50 | 0.12 | 0.95 |
| example2 | 0 | 0 | 0.25 | 0.58 | 0.05 | 0.08 | 0.65 | 0.13 | 0.90 |
| example3 | 0 | 0 | 0.22 | 0.60 | 0.05 | 0.10 | 0.80 | 0.13 | 1.00 |
| example4 | 0 | 0 | 0.23 | 0.51 | 0.06 | 0.08 | 0.65 | 0.12 | 0.90 |
| example5 | 0 | 0 | 0.19 | 0.60 | 0.07 | 0.07 | 0.50 | 0.12 | 0.90 |
| comparative example1 | 0.009 | 0.009 | 1.81 | 1.99 | 0.08 | 0.24 | 1.65 | 0.13 | 0.95 |
| comparative example2 | 0.010 | 0.013 | 2.03 | 1.68 | 0.09 | 0.18 | 1.25 | 0.14 | 1.00 |
| comparative example3 | 0.008 | 0.015 | 1.68 | 1.77 | 0.08 | 0.11 | 0.90 | 0.12 | 0.95 |

※ In the case of avarage intensity of less than 0.5,it is lower than detection limit, therefore the relative intensity thereof is represented as 「0」

[Table 3]

| | crystal grain of length of 5 μm or more existing surface ratio | result of EBSP analysis color tone ratio of range of blue system of Fig.1 | X-ray diffraction relative intensity {(331)intensity/ (111)intensity} × 100 |
|---|---|---|---|
| example1 | 80 | 89 | 41 |
| example2 | 93 | 90 | 22 |
| example3 | 91 | 93 | 25 |
| example4 | 95 | 91 | 33 |
| example5 | 82 | 92 | 23 |
| comparative example1 | 10 | 44 | 7 |
| comparative example2 | 10 | 48 | 7 |
| comparative example3 | 15 | 45 | 6 |

[Table 4]

| | mechanical property | | | number of bending comparison result |
|---|---|---|---|---|
| | tensile strength (KN/cm$^2$) | 0.2% proof stress (KN/cm$^2$) | elongation (%) | |
| example1 | 19 | 9.3 | 9 | 3.0 |
| example2 | 16 | 8.5 | 8 | 3.8 |
| example3 | 18 | 7.5 | 10 | 4.3 |
| example4 | 14 | 6.0 | 5 | 5.5 |
| example5 | 20 | 9.5 | 10 | 2.8 |
| comparative example1 | 23 | 20 | 12 | 1 |
| comparative example2 | 22 | 19 | 13 | 1.1 |
| comparative example3 | 21 | 18 | 14 | 1.2 |

※ mechanical property data is that of copper foil sample after thermal treatment

※ number of bending comparison result indicates numerical number in the case that the number of bending of comparative example 1 is set 1.

As apparent from Table 2, the amounts of impurity element of examples 1 to 5 were less than those of comparative examples, and surface roughnesses Rz of both matte surface and shiny surface thereof were 0.1 μm or less. Furthermore, as apparent form Table 3, regarding example 1 to 5, crystal grain of length of 5 μm or more existing surface ratios (%) were 70 % or more, single (blue system) color tone ratios were 80%or more in the EBSP analysis, and relative intensities [(331) intensity X100 / (111) intensity] in the X-ray diffraction were 15 or more. Furthermore as shown in Table 4, tensile strengths were 20 KN/cm$^2$ or less, 0.2 % stress proofs were 10 KN/cm$^2$ or less, and numbers of bending times were more then twice the of comparative examples.

In the present examples, bending properties are a little different in the causal relation of impurity distribution ratio, crystal grain diameter, and identical crystal orientation system, etc., it is understood that in comparison with comparative examples, apparently bending property is improved.

In particular, there is apparent correlation between proof stress and bending property, and it can be thought that impurity or size of crystal grain diameter causes decrease of proof stress.

As mentioned above, the present invention can provide an electrodeposited copper foil which has flexibility and bending property equal to or better than those of the rolled copper foil.

Moreover, the present invention can respond to the CCL which has flexibility and bending property using the above electrodeposited copper foil.

In particular, in the electrodeposited copper foil, mechanical property and flexibility are improved in the heat history applied at the adhesion of the electrodeposited copper foil and polyimide film, therefore, an electrodeposited copper foil for CCL can be provided more cheaply than the rolled copper foil, which can respond to miniaturization of the electric product.

**Claims**

1. An electrodeposited copper foil
   wherein regarding a crystal structure after heat treatment is applied to the electrodeposited copper foil wherein LMP (Larson-Miller parameter) defined as formula 1 is 9000 or more, either color tone of a red system or a blue system occupies 80% or more in a surface in the EBSP (Electron Backscatter Diffraction Pattern) analysis.

$$\text{Formula 1: LMP = (T+273) * (20+Log t)}$$

   wherein 20 is a material constant of copper, T is temperature (°C), and t is time (Hr).

2. An electrodeposited copper foil as set forth in claim 1 **characterized in that** relative intensity of (331) face against (111) face is 15 or more in the X-ray diffraction of the electrodeposited copper foil after the heat treatment is applied to the electrodeposited copper foil.

3. An electrodeposited copper foil as set forth in claim 1 wherein in the crystal structure after the heat treatment is applied to the electrodeposited copper foil, crystal grains having crystal grain diameter being 5 $\mu$m or more are 70% or more, and relative intensity of (331) face against (111) face in the X-ray diffraction is 15 or more.

4. An electrodeposited copper foil as set forth in any of claims 1 to 3 wherein the electrodeposited copper foil has tensile strength of 20 KN/cm$^2$ or less and 0.2% proof stress of 10 KN/cm$^2$ or less after the heat treatment is applied to the electrodeposited copper foil.

5. An electrodeposited copper foil as set forth in any of claims 1 to 4 **characterized in that** in the SIMS (Secondary Ion Mass Spectrometry) of depth direction of cross-section of the copper foil, at least chlorine (Cl) is less than 0.5%, nitrogen (N) is less than 0.005%, and sulfur (S) is less than 0.005% as intensity ratios against copper (Cu).

6. An electrodeposited copper foil as set forth in any of claims 1 to 5 wherein as a surface roughness of at least one surface of the electrodeposited copper foil, Rz = 1.5 $\mu$m or less.

7. An electrodeposited copper foil as set forth in any of claims 1 to 6 wherein a surface treated layer is formed on at least one surface of the electrodeposited copper foil for the purpose of adhesion property, heat resistance, chemical resistance, and rust prevention.

8. A copper clad laminate **characterized in that** an electrodeposited copper foil as set forth in any of claims 1 to 7 is laminated on an insulating substrate.

# FIG.1

B

RED SYSTEM PORTION
赤系部

111

Q

A    001    P    101    C

青系部
BLUE SYSTEM PORTION

<div align="center">

**INTERNATIONAL SEARCH REPORT**

</div>

| | International application No. |
|---|---|
| | PCT/JP2009/062362 |

**A. CLASSIFICATION OF SUBJECT MATTER**
C25D1/04(2006.01)i

According to International Patent Classification (IPC) or to both national classification and IPC

**B. FIELDS SEARCHED**

Minimum documentation searched (classification system followed by classification symbols)
C25D1/04

Documentation searched other than minimum documentation to the extent that such documents are included in the fields searched

| Jitsuyo Shinan Koho | 1922–1996 | Jitsuyo Shinan Toroku Koho | 1996–2009 |
| Kokai Jitsuyo Shinan Koho | 1971–2009 | Toroku Jitsuyo Shinan Koho | 1994–2009 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 52-7819 A (The Furukawa Electric Co., Ltd.), 21 January, 1977 (21.01.77), Page 1, right column (Family: none) | 1-8 |
| Y | JP 2004-35918 A (Nippon Denkai Ltd.), 05 February, 2004 (05.02.04), Claims (Family: none) | 1-8 |
| Y | JP 2007-146289 A (Mitsui Mining & Smelting Co., Ltd.), 14 June, 2007 (14.06.07), Claims & WO 2007/052630 A1 & KR 10-2008-0064884 A & CN 101297067 A & US 2009/0166213 A | 1-8 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 September, 2009 (30.09.09) | 13 October, 2009 (13.10.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

| | **INTERNATIONAL SEARCH REPORT** | International application No. |
|---|---|---|
| | | PCT/JP2009/062362 |

C (Continuation).    DOCUMENTS CONSIDERED TO BE RELEVANT

| Category* | Citation of document, with indication, where appropriate, of the relevant passages | Relevant to claim No. |
|---|---|---|
| A | WO 2004/059040 A1  (Nikko Materials Co., Ltd.),<br>15 July, 2004 (15.07.04),<br>Claims<br>& CN 1564881 A           & EP 1607495 A1<br>& US 2006/0011488 A1     & HK 1068654 A<br>& TW 285683 B            & US 2008/0075972 A1<br>& JP 4083171 B | 1-8 |
| A | JP 2004-250777 A  (Shipley Co., L.L.C.),<br>09 September, 2004 (09.09.04),<br>Claims<br>& EP 1371757 A1          & CN 1497069 A | 1-8 |
| A | JP 2006-57177 A  (C. Uyemura & Co., Ltd.),<br>02 March, 2006 (02.03.06),<br>Claims<br>& KR 10-2006-0053951 A  & US 2006/0207886 A1<br>& CN 1900377 A | 1-8 |

Form PCT/ISA/210 (continuation of second sheet) (April 2007)